# EUROPÄISCHE PATENTSCHRIFT

(11) **EP 2 087 503 B1**
(45) Veröffentlichungstag und Bekanntmachung des Hinweises auf die Patenterteilung: **11.12.2013**
(21) Anmeldenummer: 07819513.8
(22) Anmeldetag: 31.10.2007
(51) Int. Cl.: H01J 37/32, C23F 4/00

(54) **VORRICHTUNG ZUM VORBEHANDELN VON SUBSTRATEN**
DEVICE FOR THE PRE-TREATMENT OF SUBSTRATES
DISPOSITIF DE PRÉTRAITEMENT DE SUBSTRATS

(30) Priorität: 07.11.2006 DE 202006017024 U
(43) Veröffentlichungstag der Anmeldung: 12.08.2009
(73) Patentinhaber: Fraunhofer-Gesellschaft zur Förderung der angewandten Forschung e.V., 80686 München (DE)
(72) Erfinder: HEINSS, Jens-Peter, 01309 Dresden (DE); KIRCHHOFF, Volker, 01829 Wehlen (DE); KLOSE, Lars, 01328 Dresden OT Weissig (DE); METZNER, Christoph, 01328 Dresden OT Pappritz (DE); MORGNER, Henry, 01257 Dresden (DE); SCHEFFEL, Bert, 01796 Pirna (DE)
(86) Internationale Anmeldenummer: PCT/EP2007/009482
(87) Internationale Veröffentlichungsnummer: WO 2008/055617

(56) Entgegenhaltungen:
- DE-A1- 4 301 188
- DE-A1- 4 336 681
- DE-A1-102004 012 848
- US-A1- 2004 226 514
- US-A1- 2005 001 527

## Beschreibung

Die Erfindung betrifft eine Vorrichtung zum Vorbehandeln von Substraten. Unter Vorbehandeln im Sinne dieser Erfindung sind diejenigen Bearbeitungsschritte zu verstehen, bei denen Substrate mit aus dem Plasma einer Niedervoltbogenentladungsquelle generierten Ladungsträgern beaufschlagt werden, um an Substraten ein Ätz- bzw. Reinigungsergebnis zu erzielen, um die Oberfläche der Substrate zu aktivieren oder um die Substrate für nachfolgende Bearbeitungsschritte zu erhitzen. Beschichtungsprozesse fallen hingegen nicht unter den Begriff des Vorbehandelns im Sinne dieser Erfindung. Eine erfindungsgemäße Vorrichtung ist besonders geeignet für das Vorbehandeln von flachen Substraten, wie beispielsweise Platten oder Bänder, kann jedoch auch zum Vorbehandeln von geformten Substraten, wie beispielsweise Bauteile oder Werkzeuge, verwendet werden.

### Stand der Technik

Es ist bekannt, Substratoberflächen zum Zwecke der Vorbehandlung mit Ladungsträgern zu beaufschlagen, die aus einem Plasma extrahiert werden. DE 36 06 959 A1 beschreibt so beispielsweise eine Vorrichtung, bei der eine Hohlanode und eine Gegenelektrode einen Hohlraum nahezu vollständig umschließen, in dem ein Substrat mit Kontakt zur Gegenelektrode angeordnet und einem Hochfrequenzplasma ausgesetzt ist.

Besonders bewährt haben sich Vorrichtungen, bei denen ein Plasma mittels einer Hohlkathoden-Bogenentladung erzeugt wird. Hierbei können die Vorteile dieses Entladungstyps, wie niedrige Brennspannung und hoher extrahierbarer Strom, voll zum Tragen gebracht und mit anderen Verfahren nur schwer zu erreichende Plasmadichten erzeugt werden. Dieses Grundprinzip mit Hohlkathode wurde mehrfach weiterentwickelt und modifiziert, wobei zum Teil auch ringförmige Zündanoden und ein Plasma durchdringende Magnetfelder vorgeschlagen wurden. So ist aus DE 10 2004 012 847 A1 eine Vorrichtung bekannt, bei der ein Hohlkathodenplasma zwischen zwei Polschuhen einer magnetfelderzeugenden Einrichtung ausgebildet und ein Substrat dem Plasma zum Zwecke des Plamaätzens ausgesetzt wird.

Es ist ebenfalls bekannt, dass bei Vorrichtungen zum Plasmaätzen (auch Ionenätzen oder Sputterätzen genannt) ein zu behandelndes Substrat mit einer Spannungsdifferenz (nachfolgend BIAS-Spannung genannt) gegenüber dem Plasmapotential beaufschlagt wird, um das Beschleunigen von Ladungsträgern aus dem Plasma in Richtung Substrat zu verstärken und somit die Ätzrate zu erhöhen. Bei derartigen Vorrichtungen wird eine Spannungsquelle üblicherweise zwischen dem Substrat und der Vakuumkammer oder zwischen dem Substrat und einer Elektrode der Plasmaquelle geschaltet, wobei die Elektrode auch elektrisch mit der Vakuumkammer verbunden sein kann.

Insbesondere beim Behandeln von langen Substraten, wie beispielsweise Bänder, die oftmals nicht nur durch eine Vakuumkammer sondern auch noch durch Schleusen- und Wickelkammern geführt werden müssen, ergeben sich dabei aufwändige Anforderungen hinsichtlich der elektrischen Isolation zwischen dem Substrat und der elektrischen Masse der Vakuumkammer bzw. der gesamten Anlage. Eine Berührung des Substrates mit elektrisch leitenden Anlagenteilen (also mit der elektrischen Masse der Anlage und somit der elektrischen Masse der Vakuumkammer) bewirkt zumindest eine Veränderung der Spannungsdifferenz zwischen Plasma und Substrat, was sich schon negativ auf die Qualität der Substratbehandlung auswirkt und führt im ungünstigsten Fall zum völligen Kurzschluss der Spannungsquelle. Eine derartige Kurzschlussgefahr besteht besonders bei Vorrichtungen wie aus DE 10 2004 011 178 A1 bekannt, bei denen die BIAS-Spannung zwischen dem zu behandelnden bandförmigen Substrat und der Vakuumkammer angelegt ist. Das Berühren von bandförmigen Substraten mit elektrisch leitenden Anlagenteilen, wie Teile von Kammerwänden, Schleusenöffnungen oder Wickeleinrichtungen, vollständig zu unterbinden, ist nahezu unmöglich bzw. nur mit einem wirtschaftlich nicht zu vertretenden Aufwand zu realisieren.

DE 43 01 188 A1 offenbart eine Vorrichtung zum Beschichten oder Ätzen von Substraten mittels eines HF-Plasmas, bei der das Plasmavolumen von einem Vorspannungs-Topf umgeben ist, mit welchem eine Substrat-Bias-Spannung zum Beschleunigen von Ladungsträgern zum Substrat hin bereitgestellt wird. Die Verwendung eines solchen Vorspannungs-Topfes macht den Einsatz einer zusätzlichen gitterförmigen Elektrode erforderlich, welche den Vorspannungs-Topf umhüllt, weil sich ansonsten Entladungen vom Vorspannungs-Topf zu den Vakuumkammerwänden ausbilden würden. Ein derart technisch aufwändiger Aufbau schränkt die Wirtschaftlichkeit einer solchen Vorrichtung ein.

### Aufgabenstellung

Der Erfindung liegt daher das technische Problem zugrunde, eine Vorrichtung zum Vorbehandeln von Substraten zu schaffen, mit der die dargestellten Nachteile des Standes der Technik überwunden werden. Insbesondere sollen sich durch die Vorrichtung aufwändige Isolationsmaßnahmen zwischen Substrat und der elektrischen Masse der Vorrichtung erübrigen.

Die Lösung des technischen Problems ergibt sich durch die Gegenstände mit den Merkmalen des Schutzanspruchs 1. Weitere vorteilhafte Ausgestaltungen der Erfindung ergeben sich aus den abhängigen Ansprüchen.

Eine erfindungsgemäße Vorrichtung zum Vorbehandeln eines Substrates umfasst eine in einer Vakuumkammer angeordnete Niedervoltbogenentladungsquelle zum Erzeugen eines Plasmas, aus dem Ladungsträger extrahierbar sind und mit denen die Oberfläche des Substrates beaufschlagbar ist. Dabei ist das Substrat mit der elektrischen Vakuumkammermasse verbunden und eine BIAS-Spannung für das Beschleunigen der Ladungsträger auf die Substratoberfläche zwischen Substrat und Vakuumkammermasse einerseits und einer dem Plasmapotential spannungsmäßig nahe stehenden Elektrode andererseits geschaltet.

Dadurch, dass die elektrische Masse einer Vakuumkammer/Anlage und eines zu behandelnden Substrates das gleiche elektrische Potential aufweisen, werden aufwändige elektrische Isolationsmaßnahmen zwischen Substrat und Anlagenteilen hinfällig. Der elektrische Kontakt zwischen Substrat und der elektrischen Masse der Vakuumkammer/ Anlage kann beispielsweise über einen Schleifkontakt hergestellt werden, kann aber beispielsweise auch über Transportrollen der Anlage, auf denen das Substrat bewegt wird, erfolgen.

Bei einer erfindungsgemäßen Vorrichtung besteht zwischen Plasma und Vakuumkammer die gleiche Spannungsdifferenz wie zwischen Plasma und Substrat. Aus diesem Sachverhalt ließe sich die Vermutung ableiten, dass bei einer derartigen Vorrichtung nicht nur das Substrat mit Ladungsträgern beaufschlagt wird sondern auch die Bestandteile der Vakuumkammer. Dieser Effekt ist jedoch vernachlässigbar bzw. lässt sich dieser mit einfachen Mitteln auf ein vernachlässigbares Maß reduzieren. Ein Plasma breitet sich zwar vollständig innerhalb einer Vakuumkammer aus, jedoch ist der Bereich eines Plasmas mit einer hohen Plasmadichte räumlich stark begrenzt. Ein derartiger Bereich ist gewöhnlich auf optischem Wege durch eine helle Leuchterscheinung zu erkennen. Wenn der Bereich eines Plasmas mit hoher Plasmadichte in der Nähe eines zu behandelnden Substrates erzeugt wird, ist das Bombardement von Vakuumkammerbestandteilen mit Ladungsträgern aus dem Plasma vernachlässigbar. Des Weiteren kann ein derartiger Plasmabereich mit hoher Plasmadichte mittels magnetfelderzeugender Einrichtungen noch zusätzlich in Richtung Substrat abgelenkt werden.

Als Brennspannung zwischen Kathode und Anode einer Niedervoltbogenentladungsquelle sind Spannungen im Bereich von 1 V bis 250 V möglich. Vorzugsweise werden Brennspannungen in einem Bereich von 10 V bis 40 V verwendet, da unter 10 V die Wirksamkeit dahingehend eingeschränkt ist, dass nur geringe Stromdichten erzielbar sind, und über 40 V die Gefahr von Spannungsüberschlägen besteht.

Wie bereits dargelegt, ist es für ein positives Behandlungsergebnis vorteilhaft, wenn ein zu behandelndes Substrat gegenüber einem Plasma mit einer BIAS-Spannung beaufschlagt wird. Da es keine Möglichkeit gibt das Spannungspotential eines Plasmas direkt mit Anschlüssen am Plasma abzugreifen, kann eine Elektrode, die in einem Plasma oder in dessen Nähe angeordnet ist, auch meistens nur annähernd das Spannungspotential des Plasmas aufweisen. In diesem Zusammenhang ist der Begriff "dem Plasmapotential spannungsmäßig nahe stehende Elektrode" zu verstehen. Wichtig ist hierbei, dass für gleichmäßige Behandlungsergebnisse eine weitgehend gleich bleibende Spannungsdifferenz vom Plasma zum Substrat aufrechterhalten wird. Ob die Elektrode dabei exakt das Spannungspotential des Plasmas aufweist oder nur annähernd, ist hingegen nicht von ausschlaggebender Bedeutung.

Als Elektrode für das Anlegen einer Substrat-BIAS-Spannung wird erfindungsgemäß die Kathode oder eine Anode der Niedervoltbogenentladungsquelle verwendet werden, wobei das Spannungspotential einer Anode gewöhnlich näher am Plasmapotential liegt und daher oftmals besser geeignet ist.

Vorteilhaft hohe Plasmadichten lassen sich erzielen, wenn die Kathode einer Niedervoltbogenentladungsquelle als Hohlkathode ausgebildet ist. Zum Betreiben eines Hohlkathodenplasmas ist es erforderlich, ein Gas durch die Hohlkathode in die Vakuumkammer einzulassen. Hierbei sind Gase geeignet, die eines oder mehrere der Elemente Argon, Stickstoff oder Wasserstoff aufweisen. Wird zum Zünden einer Hohlkathode eine ringförmig ausgebildete Hilfs-/Zündanode verwendet, kann auch diese Ringanode als Elektrode für das Anlegen der Substrat-BIAS-Spannung eingesetzt werden.

Als BIAS-Spannung sind sowohl Gleichspannungen als auch Wechselspannungen in einem Bereich von 20 V bis 5000 V und vorzugsweise in einem Bereich von 200 V bis 500 V geeignet. Dabei kann eine BIAS-Spannung als unipolar oder bipolar gepulste Spannung ausgebildet sein, wobei Pulstaktraten in einem Bereich von 1 kHz bis 200 kHz zu bevorzugen sind.

Wird an ein zu behandelndes Substrat eine BIAS-Spannung angelegt, die gegenüber dem Plasma ein negatives Potential aufweist, werden positive Ionen aus dem Plasma extrahiert und in Richtung Substrat beschleunigt. Eine derart ausgebildete erfindungsgemäße Vorrichtung ist zum Ionenätzen von Substratoberflächen geeignet. Hierbei lassen sich Ionenströme zum Substrat in einem Bereich von 1 A bis 300 A extrahieren. Die Stärke des zu extrahierenden Ionenstromes hängt von der Aufgabenstellung ab. Allgemein kann festgehalten werden, dass mit steigenden Ionenströmen höhere Ätzraten zu erzielen sind.

Alternativ besteht die Möglichkeit, ein zu behandelndes Substrat mit einer positiven BIAS-Spannung zu beaufschlagen. Auf diese Weise werden Elektronen aus einem Plasma extrahiert und in Richtung Substrat beschleunigt. Eine derartige Vorrichtung kann verwendet werden, um die Oberfläche eines Substrates zu aktivieren bzw. um das Substrat aufzuheizen. Je nach Aufgabenstellung können hierbei Elektronenströme von 1 A bis 3000 A generiert werden. Auch hier gilt das gleiche Prinzip, dass mit steigendem Elektronenstrom auch die Intensität des Behandlungsergebnisses ansteigt.

Es ist selbstverständlich auch im Sinne der Erfindung zu betrachten, wenn eine Vorrichtung mehrere Niedervoltbogenentladungsquellen umfasst, um beispielsweise die gleichzeitig zu bearbeitende Fläche an einem zu behandelnden Substrat zu erhöhen.

Die Erfindung wird nachfolgend anhand bevorzugter Ausführungsbeispiele näher erläutert. Die Fig. zeigen:
- Fig. 1: eine schematische Darstellung einer erfindungsgemäßen Vorrichtung zum Ionenätzen;
- Fig. 2: eine graphische Darstellung einer alternativen erfindungsgemäßen Vorrichtung zum Ionenätzen;

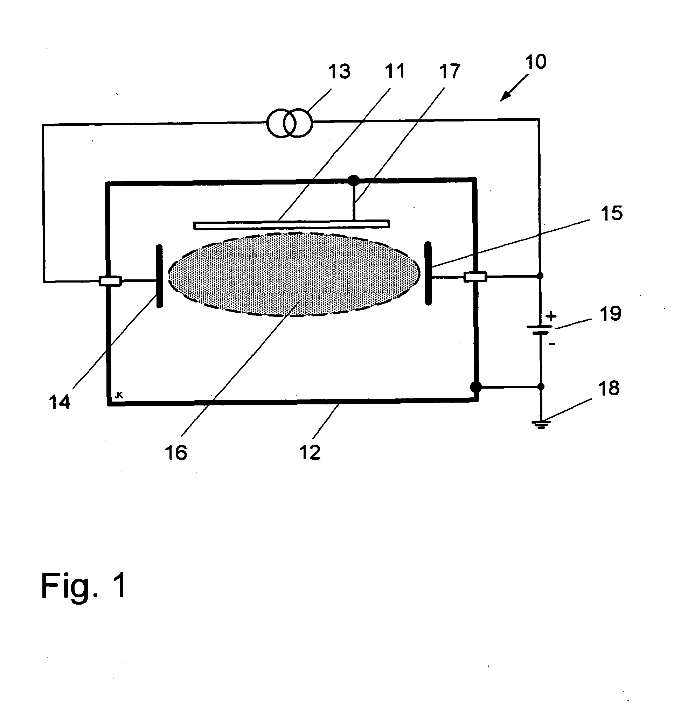

In Fig. 1 ist eine Anlage 10 zum Ionenätzen eines bandförmigen Substrates 11 in einer Vakuumkammer 12 schematisch dargestellt. Substrat 11, welches in Fig. 1 im Querschnitt dargestellt ist, wird sowohl durch die Vakuumkammer 12 als auch durch nicht dargestellte Schleusen- und Wickelkammern der Anlage 10 geführt. Mittels einer Stromquelle 13 wird eine Entladung zwischen einer Kathode 14 und einer Anode 15 in Vakuumkammer 12 aufrechterhalten. Auf diese Weise wird zwischen Kathode 14 und Anode 15 in einem Bereich 16 ein Plasma mit hoher Plasmadichte erzeugt. Über eine elektrische Verbindung 17 ist das Substrat 11 mit der Vakuumkammer 12 elektrisch verbunden. Sowohl Substrat 11 als auch Vakuumkammer 12 weisen das Spannungspotential der Anlagenmasse 18 auf.

Von der Anode 15, welche annähernd das Spannungspotential des Plasmas 16 aufweist, wird über eine Spannungsquelle 19 eine negative BIAS-Spannung an das Substrat 11 angelegt, aufgrund der positive Ionen aus dem Plasma 16 extrahiert und in Richtung Substrat 11 beschleunigt werden. Da das Substrat 11 das gleiche Spannungspotential aufweist wie die elektrische Masse der Anlage 10, hat eine Berührung von Substrat 11 mit Teilen der Anlage 10 (die mit dem Massepotential von Anlage 10 verbunden sind) keine negativen Auswirkungen auf die Qualität des Ätzprozesses.

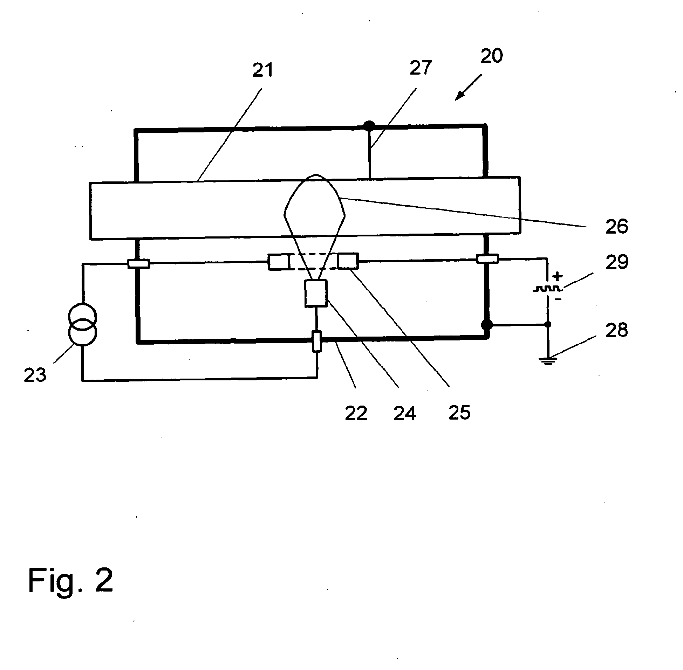

In Fig. 2 ist eine Anlage 20 zum Ionenätzen eines Substrates 21 in einer Vakuumkammer 22 schematisch dargestellt. Bei Substrat 21 handelt es sich um ein 200 mm breites, 0.5 mm dickes und 100 m langes und in Fig. 2 als Draufsicht dargestelltes Stahlband, das sowohl durch die Vakuumkammer 22 als auch durch nicht dargestellte Schleusen- und Wickelkammern der Anlage 20 geführt wird. Mittels einer Stromquelle 23 wird eine Entladung zwischen einer Hohlkathode 24 und einer ringförmig ausgebildeten Anode 25 in Vakuumkammer 22 aufrechterhalten. Die Entladungsspannung beträgt dabei 20 V und der Entladungsstrom 150 A. Auf diese Weise wird ausgehend von Hohlkathode 24 in einem Bereich 26 ein Plasma mit hoher Plasmadichte erzeugt. Über eine Leitung 27 ist das Substrat 21 mit der Vakuumkammer 22 elektrisch verbunden. Sowohl Substrat 21 als auch Vakuumkammer 22 weisen das Spannungspotential der Anlagenmasse 28 auf.

Von der Ringanode 25, welche annähernd das Spannungspotential des Plasmas 26 aufweist, wird über eine Spannungsquelle 29 eine unipolar gepulste BIAS-Spannung von 300 V an das Substrat 21 angelegt, aufgrund der positive Ionen aus dem Plasma 26 mit einer Stromstärke von 10 A extrahiert und in Richtung Substrat 21 beschleunigt werden. Unter den angegebenen Bedingungen konnte am bewegten Substrat eine Abtragsrate von 3 nm*m/s erzielt werden.

## Patentansprüche

1. Vorrichtung zum Vorbehandeln mindestens eines Substrates (21), umfassend eine in einer Vakuumkammer (22) angeordnete Niedervoltbogenentladungsquelle (24; 25) zum Erzeugen eines Plasmas (26), aus dem Ladungsträger extrahierbar sind, mit denen die Oberfläche des Substrates (21) beaufschlagbar ist, wobei die Niedervoltbogenentladungsquelle eine Kathode (24), eine Anode (25) und eine Stromquelle (23) zum Aufrechterhalten einer Entladung zwischen Kathode (24) und Anode (25) umfasst, und einer Spannungsquelle (29) zur Erzeugung einer BIAS-Spannung für das Beschleunigen der Ladungsträger auf die Substratoberfläche, wobei im Betrieb das Substrat (21) mit der elektrischen Vakuumkammermasse (28) verbunden ist und die BIAS-Spannung zwischen Substrat (21) und Vakuumkammermasse (28) einerseits und einer dem Plasmapotential spannungsmäßig nahe stehenden Elektrode andererseits geschaltet ist, **dadurch gekennzeichnet, dass** die Elektrode eine Kathode oder eine Anode (25) der Niedervoltbogenentladungsquelle (24; 25) ist.

2. Vorrichtung nach Anspruch 1, **dadurch gekennzeichnet, dass** die Anode (25) als Ringanode ausgebildet ist.

3. Vorrichtung nach einem der vorhergehenden Ansprüche, **dadurch gekennzeichnet, dass** die BIAS-Spannung einen Wert von 20 V bis 5000 V und vorzugsweise von 200 V bis 500 V aufweist.

4. Vorrichtung nach einem der vorhergehenden Ansprüche, **dadurch gekennzeichnet, dass** die BIAS-Spannung als Gleichspannung oder als Wechselspannung ausgebildet ist.

5. Vorrichtung nach einem der vorhergehenden Ansprüche, **dadurch gekennzeichnet, dass** die BIAS-Spannung als unipolar oder bipolar gepulste Spannung ausgebildet ist.

6. Vorrichtung nach einem der vorhergehenden Ansprüche, **dadurch gekennzeichnet, dass** das Substrat (21) im Betrieb gegenüber dem Plasma (26) ein negatives elektrisches Potential oder ein positives elektrisches Potential aufweist.

7. Vorrichtung nach einem der vorhergehenden Ansprüche, **dadurch gekennzeichnet, dass** im Betrieb zwischen Kathode und Anode der Niedervoltbogenentladungsquelle eine Entladungsspannung von 1 V bis 250 V und vorzugsweise von 10 V bis 40 V ausgebildet ist.

8. Vorrichtung nach einem der vorhergehenden Ansprüche, **dadurch gekennzeichnet, dass** aus dem Plasma ein Ionenstrom zum Substrat von 1 A bis 300 A extrahierbar ist.

9. Vorrichtung nach einem der vorhergehenden Ansprüche, **dadurch gekennzeichnet, dass** aus dem Plasma ein Elektronenstrom zum Substrat von 1 A bis 3000 A extrahierbar ist.

10. Vorrichtung nach einem der vorhergehenden Ansprüche, **dadurch gekennzeichnet, dass** die Kathode (24) der Niedervoltbogenentladungsquelle (24; 25) als Hohlkathode ausgebildet ist.

11. Vorrichtung nach Anspruch 10, **dadurch gekennzeichnet, dass** durch die Hohlkathode Argon, Stickstoff, Wasserstoff oder ein Gasgemisch, das eines oder mehrere der genannten Elemente umfasst, in die Vakuumkammer einlassbar ist.

12. Vorrichtung nach einem der vorhergehenden Ansprüche, **gekennzeichnet durch** eine Einrichtung zum Erzeugen eines Magnetfeldes, mittels dem das Plasma zum Substrat hin ablenkbar ist.

13. Vorrichtung nach einem der vorhergehenden Ansprüche, **dadurch gekennzeichnet, dass** im Betrieb das Plasma in Substratnähe angeordnet ist.

14. Vorrichtung nach einem der vorhergehenden Ansprüche, **dadurch gekennzeichnet, dass** im Betrieb das Plasma in Substratnähe eine höhere Plasmadichte aufweist als in Nähe der Vakuumkammerwände.

## Claims

1. Device for the pre-treatment of at least one substrate (21), comprising a low-voltage arc discharge source (24; 25), arranged in a vacuum chamber (22), for generating a plasma (26), from which there can be extracted charge carriers, which can be applied to the surface of the substrate (21), the low-voltage arc discharge source comprising a cathode (24), an anode (25) and a power source (25) for maintaining a discharge between the cathode (24) and the anode (25), and a voltage source (29) for generating a BIAS voltage for the acceleration of the charge carriers onto the substrate surface, the substrate (21) being connected to the electrical ground of the vacuum chamber (28) and the BIAS voltage being switched between on the one hand the substrate (21) and the vacuum chamber mass (28) and on the other hand an electrode close to the plasma potential in terms of voltage during operation, **characterized in that** the electrode is a cathode or an anode (25) of the low-voltage arc discharge source (24; 25).

2. Device according to Claim 1, **characterized in that** the anode (25) is formed as an annular anode.

3. Device according to one of the preceding claims, **characterized in that** the BIAS voltage has a value of 20 V to 5000 V and preferably of 200 V to 500 V.

4. Device according to one of the preceding claims, **characterized in that** the BIAS voltage is formed as a DC voltage or as an AC voltage.

5. Device according to one of the preceding claims, **characterized in that** the BIAS voltage is formed as a unipolar or bipolar pulsed voltage.

6. Device according to one of the preceding claims, **characterized in that** the substrate (21) has a negative electric potential or a positive electric potential with respect to the plasma (26) during operation.

7. Device according to one of the preceding claims, **characterized in that** a discharge voltage of 1 V to 250 V and preferably of 10 V to 40 V is formed between the cathode and the anode of the low-voltage arc discharge source during operation.

8. Device according to one of the preceding claims, **characterized in that** an ion current to the substrate of 1 A to 300 A can be extracted from the plasma.

9. Device according to one of the preceding claims, **characterized in that** an electron current to the substrate of 1 A to 3000 A can be extracted from the plasma.

10. Device according to one of the preceding claims, **characterized in that** the cathode (24) of the low-voltage arc discharge source (24; 25) is formed as a hollow cathode.

11. Device according to Claim 10, **characterized in that** argon, nitrogen, hydrogen or a gas mixture that comprises one or more of the elements mentioned can be admitted into the vacuum chamber through the hollow cathode.

12. Device according to one of the preceding claims, **characterized by** a means for generating a magnetic field, by means of which the plasma can be deflected towards the substrate.

13. Device according to one of the preceding claims, **characterized in that** the plasma is arranged in the vicinity of the substrate during operation.

14. Device according to one of the preceding claims, **characterized in that** the plasma has a higher plasma density in the vicinity of the substrate than in the vicinity of the vacuum chamber walls during operation.

## Revendications

1. Dispositif de prétraitement d'au moins un substrat (21), comprenant une source de décharge d'arc basse tension (24 ; 25) disposée dans une chambre sous vide (22) pour générer un plasma (26) à partir duquel peuvent être extraits des porteurs de charge avec lesquels peut être chargée la surface du substrat (21), la source de décharge d'arc basse tension comprenant une cathode (24), une anode (25) et une source de courant (23) pour maintenir une décharge entre la cathode (24) et l'anode (25) et une source de tension (29) destinée à générer une tension de polarisation pour l'accélération des porteurs de charge sur la surface du substrat, le substrat (21), en fonctionnement, étant relié avec la masse électrique de la chambre sous vide (28) et la tension de polarisation étant connectée entre le substrat (21) et la terre de la chambre sous vide (28) d'un côté et une électrode dont la tension est proche du potentiel de plasma de l'autre côté, **caractérisé en ce que** l'électrode est une cathode ou une anode (25) de la source de décharge d'arc basse tension (24 ; 25).

2. Dispositif selon la revendication 1, **caractérisé en ce que** l'anode (25) est réalisée sous la forme d'une anode annulaire.

3. Dispositif selon l'une des revendications précédentes, **caractérisé en ce que** la tension de polarisation présente une valeur de 20 V à 5000 V et de préférence de 200 V à 500 V.

4. Dispositif selon l'une des revendications précédentes, **caractérisé en ce que** la tension de polarisation est réalisée sous la forme d'une tension continue ou d'une tension alternative.

5. Dispositif selon l'une des revendications précédentes, **caractérisé en ce que** la tension de polarisation est réalisée sous la forme d'une tension impulsionnelle unipolaire ou bipolaire.

6. Dispositif selon l'une des revendications précédentes, **caractérisé en ce que** le substrat (21), en fonctionnement, présente par rapport au plasma (26) un potentiel électrique négatif ou un potentiel électrique positif.

7. Dispositif selon l'une des revendications précédentes, **caractérisé en ce qu'**en fonctionnement, une tension de décharge de 1 V à 250 V et de préférence de 10 V à 40 V est formée entre la cathode et l'anode de la source de décharge d'arc basse tension.

8. Dispositif selon l'une des revendications précédentes, **caractérisé en ce qu'**un flux d'ions vers le substrat de 1 A à 300 A peut être extrait du plasma.

9. Dispositif selon l'une des revendications précédentes, **caractérisé en ce qu'**un flux d'électrons vers le substrat de 1 A à 3000 A peut être extrait du plasma.

10. Dispositif selon l'une des revendications précédentes, **caractérisé en ce que** la cathode (24) de la source de décharge d'arc basse tension (24 ; 25) est réalisée sous la forme d'une cathode creuse.

11. Dispositif selon la revendication 10, **caractérisé en ce que** de l'argon, de l'azote, de l'hydrogène ou un mélange gazeux qui inclut un ou plusieurs des éléments mentionnés peut être introduit dans la chambre sous vide à travers la cathode creuse.

12. Dispositif selon l'une des revendications précédentes, **caractérisé par** un équipement pour générer un champ magnétique au moyen duquel le plasma peut être dévié en direction du substrat.

13. Dispositif selon l'une des revendications précédentes, **caractérisé en ce qu'**en fonctionnement, le plasma est disposé à proximité du substrat.

14. Dispositif selon l'une des revendications précédentes, **caractérisé en ce qu'**en fonctionnement, le plasma présente à proximité du substrat une densité de plasma plus élevée qu'à proximité des parois de la chambre sous vide.
